Europäisches Patentamt

European Patent Office

Office européen des brevets

(11) Publication number: **0 083 229**
**B1**

(12) **EUROPEAN PATENT SPECIFICATION**

(45) Date of publication of patent specification: **03.08.88**

(51) Int. Cl.⁴: **G 11 C 11/24**

(21) Application number: **82306938.0**

(22) Date of filing: **23.12.82**

(54) Semiconductor memory device.

(30) Priority: **26.12.81 JP 212934/81**

(43) Date of publication of application:
**06.07.83 Bulletin 83/27**

(45) Publication of the grant of the patent:
**03.08.88 Bulletin 88/31**

(84) Designated Contracting States:
**DE FR GB**

(56) References cited:
**EP-A-0 037 239**

**PATENTS ABSTRACTS OF JAPAN, vol. 2, no. 42, page 495 E 78, 20th March 1978**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**20-5-9-301, Utsukushigaoka 1-chome Midori-ku**
**Yokohama-shi Kanagawa 227 (JP)**
Inventor: **Nozaki, Shigeki**
**Mezon-hisasue 203, 473, Hisasue Takatsu-ku**
**Kawasaki-shi Kanagawa 213 (JP)**
Inventor: **Ohira, Tsuyoshi**
**Kurashi-no-kyoshitsu 102 125, Mizonokuchi**
**Takatsu-ku Kawasaki-shi Kanagawa 213 (JP)**

(74) Representative: **Fane, Christopher Robin King et al**
**HASELTINE LAKE & CO. Hazlitt House 28 Southampton Buildings Chancery Lane London, WC2A 1AT (GB)**

Courier Press, Leamington Spa, England.

## Description

The present invention relates to a semiconductor memory device and, more particularly, to the data output portion thereof.

The construction of a large memory system utilizing a plurality of semiconductor memory devices (integrated circuits) arranged in rows and columns, for example a memory system constructed with 4 rows×8 columns so as to perform an 8-bit parallel data processing operation, is well known. In such a case, the data output terminals of the memory devices arranged in each column are connected to a common data bus.

In the above-mentioned memory system, however, when the system is in a transient state wherein the power supply is turned on, respective signals enabling the output portions of two or more memory devices in one column may be produced prematurely and those devices may thus assume a read-mode state. If this happens, a large short-circuit current flows from one such memory device to another such memory device through a data bus, possibly damaging the output transistors of the data output portions and disconnecting the aluminum connections of the output transistors.

Thus it is desirable to provide a semiconductor memory device for use in the above-mentioned memory system in which no short-circuit current is generated when the power supply is turned on.

According to the present invention there is provided a semiconductor memory device comprising:

first and second power supply lines, the said second power supply line being maintained at a higher potential than the first when the device is in normal operation;

data output circuitry, connected between the said first and second power supply lines, having respective inputs for receiving data signals and an output enable signal and operative, upon receipt of the said output enable signal, to provide an output signal dependent upon the received data signals; and

output enabling circuitry, connected between the said first and second power supply lines, having inputs for receiving clock signals and having an output stage, connected to the said data output circuitry, for delivering the said output enable signal at times determined by the received clock signals when the device is in normal operation, which output enabling circuitry includes a bootstrap circuit arrangement having a node connected to an input of the output stage so as to cause the said output enable signal to be produced when the potential at the said node is pulled up by bootstrap action initiated by a received clock signal;

characterised by output disabling circuitry, connected between the said first and second power supply lines and to the said output enabling circuitry, for preventing the generation of the said output enable signal during an initial period of time, following application of power to the first and second supply lines, during which the potential of the said second power supply line is increasing to its normal operating value, without preventing the said bootstrap action and consequent production of the said output enable signal during subsequent normal operation.

In JP—A—53 8526 a semiconductor memory device is provided with a type of output disabling circuitry which provides protection for output transistors of a level conversion circuit, the said transistors being connected between high and low potential lines. In some circumstances, in the absence of that output disabling circuitry, the potentials at the gates of those transistors may float, and in this state the transistors are liable to break down through overcurrent. The presence of the output disabling circuitry employed in JP—A—53 8526 serves to ground the gates of (and hence switch off) those transistors, in order to avoid such breakdown. Unlike the output disabling circuitry of the present invention, however, JP—A—53 8526 is not concerned with preventing the premature production of an output enabling signal so as to prevent a large short-circuit current from flowing from one memory device to another when the power supply is first switched on, and there is no suggestion or indication that output disabling circuitry of any type could be employed for that purpose.

EP—A—0 037 239 shows an alternative use of a type of output disabling circuitry. This prior art document is concerned with minimising the number of pins that it is necessary to provide on an integrated circuit, in addition to reducing the power consumption of that circuit, and with these purposes in mind output disabling circuitry is used to prevent data being applied by a data output buffer to an input/output pin of an integrated circuit, when that pin is to be used as an input for a dynamic data write-in buffer. EP—A—0 037 239 is not concerned with the problem addressed by the present application and, hence, there is no suggestion or indication that a type of output disabling circuitry could or should be used to overcome that problem. Furthermore, the output disabling circuitry proposed in EP—A—0 037 239 is not readily adapatable to overcome the problem with which the present application is concerned.

Figure 1 is a block circuit diagram illustrating a general memory system;

Figure 2 is a block circuit diagram of one of the semiconductor memory devices of Figure 1;

Figure 3 is a circuit diagram illustrating a data output portion of a previously proposed memory device;

Figures 4 and 5 are timing diagrams illustrating the operation of the circuit of Figure 3;

Figure 6 is a circuit diagram illustrating a problem in the memory system of Figure 1 utilizing the device of Figure 3;

Figures 7 and 8 are circuit diagrams illustrating respective data output portions of semiconductor memory devices embodying the present invention; and

Figures 9 and 10 are timing diagrams illustrating the operation of the circuit of Figures 7 and 8.

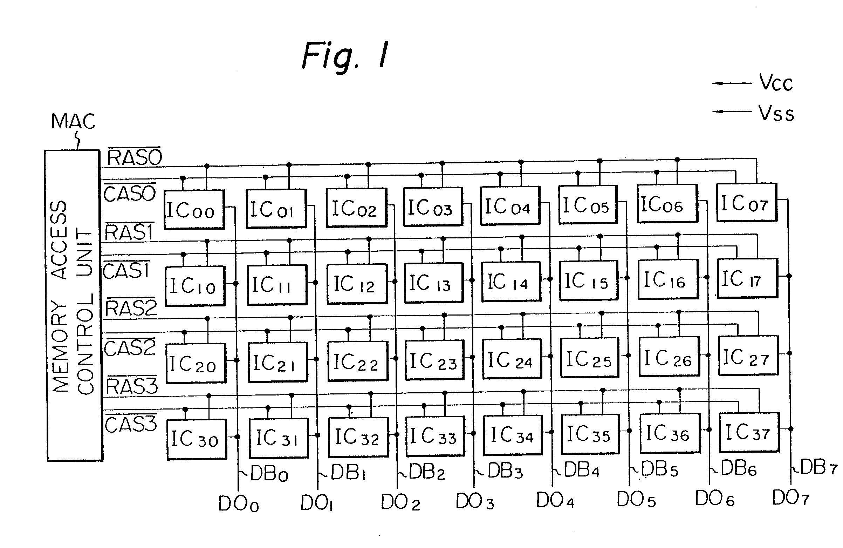

In Figure 1, $IC_{00}$, $IC_{01}$, ..., $IC_{07}$, $IC_{10}$, $IC_{11}$, ..., $IC_{17}$, $IC_{20}$, $IC_{21}$, ..., $IC_{27}$, and $IC_{30}$, $IC_{31}$, ..., $IC_{37}$ designate respective 64K dynamic random-access memory (RAM) devices. That is, 4×8 memory devices form four groups, and each group is controlled by a memory access control unit MAC. $DB_0$, $DB_1$, ..., and $DB_7$ designate data buses, and $DO_0$, $DO_1$, ..., and $DO_7$ designate eight pieces of parallel data. Other signals, such as address signals and a write enable signal (WE), are not shown.

In the read mode, when the memory access control unit MAC makes a row address strobe signal RAS0 low, each of the memory devices $IC_{00}$, $IC_{01}$, ..., and $IC_{07}$ takes in a row address. Next, when the memory access control unit MAC makes a column address strobe signal CAS0 low, each of the memory devices $IC_{00}$, $IC_{01}$, ..., and $IC_{07}$ takes in a column address. As a result, memory data $DO_0$, $DO_1$, ..., and $DO_7$ of the memory cells of the devices $IC_{00}$, $IC_{01}$, ..., and $IC_{07}$ designated by the above-mentioned row and column addresses is read out of the data buses $DB_0$, $DB_1$, ..., and $DB_7$. Similarly, when the memory access control unit MAC makes a row address strobe signal $\overline{RAS1}$ low and then makes a column address strobe signal $\overline{CAS1}$ low, memory data $DO_0$, $DO_1$, ..., and $DO_7$ of the memory cells of the devices $IC_{10}$, $IC_{11}$, ..., and $IC_{17}$ is read out of the data buses $DB_0$, $DB_1$, ..., and $DB_7$.

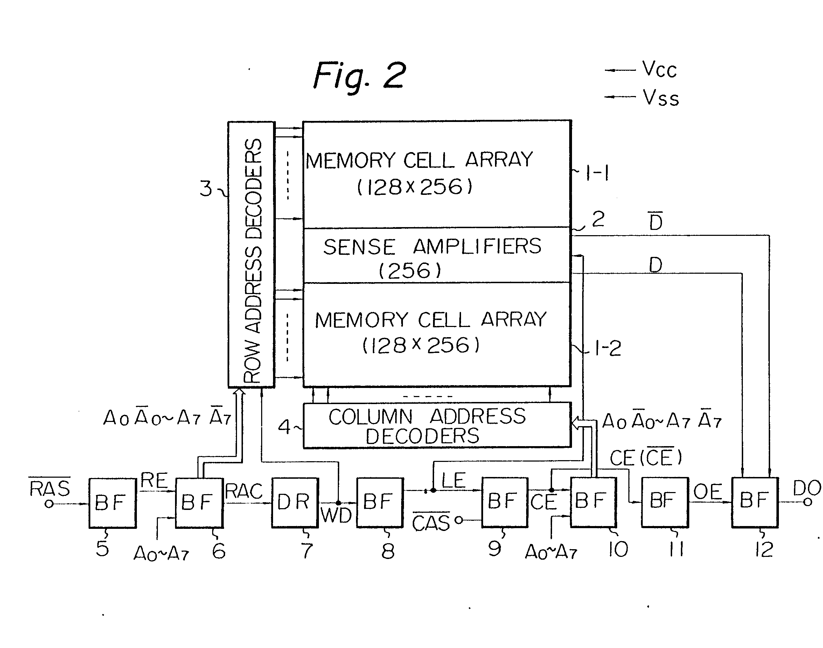

In Figure 2, which illustrates one of the memory devices $IC_{00}$, $IC_{01}$, ... of Figure 1, reference numerals 1-1 and 1-2 designate memory cell arrays, each array including 32 kbit (128×256) memory cells; 2 designates a series of 256 sense amplifiers between the memory cell arrays 1-1 and 1-2; 3 designates row address decoders including word drivers; and 4 designates column address decoders. The row address decoders 3 select one of 256 rows specified by a logic combination of the row address signals $A_0$ and $\overline{A}_0$ through $A_7$ and $\overline{A}_7$. In this case, the word drivers of the row address decoders 3 are clocked by a word line-driving signal WD.

The row address decoders 3 which select one of the 256 rows are controlled by a row enable buffer 5, a row address buffer 6, and a word line driver 7. In more detail, the row enable buffer 5 converts a row address signal $\overline{RAS}$ of a transistor-transistor logic (TTL) level from the exterior of the device into a row enable signal RE of a metal-oxide semiconductor (MOS) level. In an access mode, such as the read mode, the row address buffer 6 converts the row address signals $A_0$ through $A_7$ of a TTL level from the exterior of the device into the row address signals $A_0$, $\overline{A}_0$ through $A_7$, $\overline{A}_7$ of a MOS level. This conversion is clocked by the row enable signal RE transmitted from the row enable buffer 5. Simultaneously, the row address buffer 6 receives the row enable signal RE so as to generate a row address clock signal RAC. The word line driver 7 receives the row address clock signal RAC so as to generate a word line-driving signal WD. As a result, all of the word drivers included in the row address decoders 3 are clocked. A latch enable buffer 8 receives the word line-driving signal WD so as to generate a latch enable signal LE. As a result, all of the sense amplifiers 2 are activated.

One of the 256 columns is selected by a column enable buffer 9 and a column address buffer 10. In more detail, the column enable buffer 9 receives the latch enable signal LE and a column address strobe signal CAS from the exterior of the device so as to generate a column enable signal CE. Therefore, this column selection is performed after row selection. Next, the column address buffer 10 converts the column address signals $A_0$ through $A_7$ of a TTL level from the exterior of the device into the column address signals $A_0$, $\overline{A}_0$ through $A_7$, $\overline{A}_7$ of a MOS level so that the column address decoders 4 select one of the 256 columns. This conversion is clocked by the column enable signal CE transmitted from the column enable buffer 9.

Reference numeral 11 designates a data output enable buffer which is driven or clocked by the column enable signal CE and its inverted signal $\overline{CE}$ to generate an output enable signal OE which is transmitted to a data output buffer 12. The data output buffer 12 transmits data, read out of the sense amplifiers 2 as output data DO through data output lines D and $\overline{D}$, to the exterior of the device.

An embodiment of the present invention can provide an improvement over the data output portion, that is the data output enable buffer 11 and the data output buffer 12, of Figure 2, which portion will now be explained in more detail.

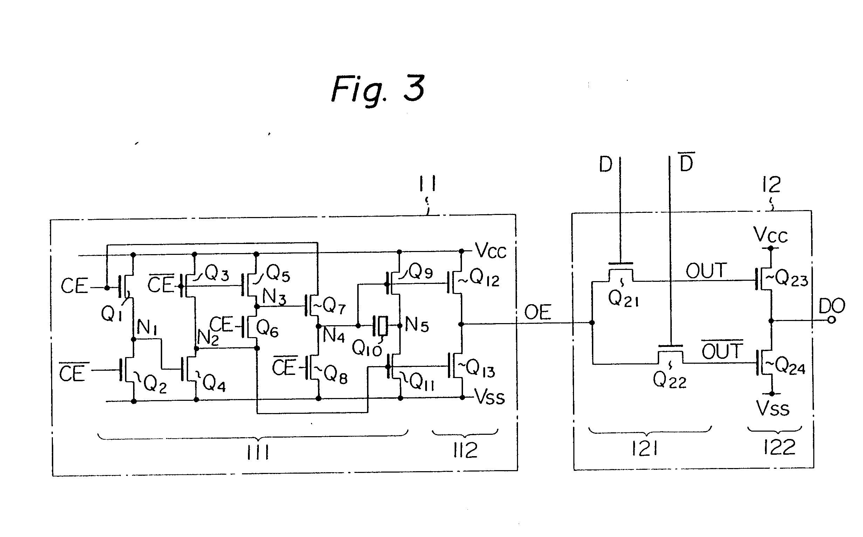

In Figure 3, which illustrates a previously proposed data output portion circuit, the data output enable buffer 11 comprises a bootstrap circuit 111, driven or clocked by the column enable signals CE and $\overline{CE}$, and an output stage 112 for delivering an output enable signal OE to the data output buffer 12. $N_4$ is a node boosted by the bootstrap circuit 111. The data output buffer 12 comprises a data transfer circuit 121, connected to the data output lines D and $\overline{D}$ and to the output enable signal-generating circuit 112, and a data output stage 122.

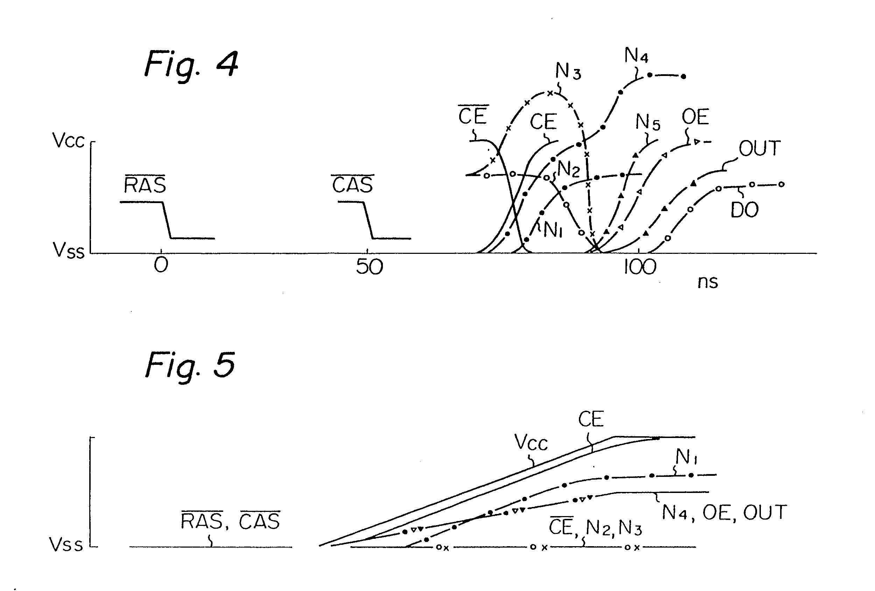

The normal operation of the circuit of Figure 3 is now explained with reference to Figure 4. Assume that the power supply voltage $V_{cc}$ remains at a normal value. When the row address strobe signal $\overline{RAS}$ and the column address strobe signal $\overline{CAS}$ both remain at a high level, the column enable signals CE and $\overline{CE}$ are low ($V_{ss}$) and high ($V_{cc}$), respectively. Therefore, in the bootstrap circuit 111, the transistors $Q_2$, $Q_3$, $Q_5$, $Q_8$, and $Q_{11}$ are turned on and the others are turned off. As a result, the potential at the nodes $N_1$, $N_4$, and $N_5$ remains low ($V_{ss}$) while the potential at the other nodes remain high ($V_{cc}$—$V_{th}$). In order to perform a read operation, when the row address signal $\overline{RAS}$ is caused to be low and then the column address signal $\overline{CAS}$ is caused to be low, the potential of the column enable signal CE is changed from low ($V_{ss}$) to high ($V_{cc}$) while the potential of the column enable signal $\overline{CE}$ is changed from high ($V_{cc}$) to low ($V_{ss}$). As a result, the potential at the node $N_3$ is pushed up by the capacitive coupling of the gate and drain of the transistor $Q_7$. In addition, the transistor $Q_1$ is turned on, with the result that the potential at the node $N_1$ is increased so as to turn on the transistor $Q_4$, which, in turn, decreases the potential at the node $N_2$. Further, since the transistor

$Q_7$ is turned on due to the high potential at the node $N_3$, the potential at the node $N_4$ rises in accordance with a rise in the potential of the signal CE. As the potential at the node $N_2$ decreases, the transistors $Q_{11}$ and $Q_{13}$ are turned off, and, in addition, the potential at the node $N_3$ falls. Finally, the transistor $Q_7$ is turned off, with the result that the node $N_4$ assumes a floating state (since $Q_8$ is also off). When the node $N_4$ is in a floating state, the conductive transistor $Q_9$ pushes up the potential at the node $N_5$, and the potential at the node $N_4$ is further pushed up, due to the bootstrap effect, by the MOS capacitor $Q_{10}$. As a result, the transistors $Q_9$ and $Q_{12}$ are completely turned on and thereby the potential of the output enable signal OE reaches $V_{cc}$.

In the data output buffer 12, assume that the potentials of the data output lines D and $\bar{D}$ are high $(V_{cc})$ and low $(V_{ss})$, respectively. In such a case, the transistors $Q_{21}$ and $Q_{22}$ are turned on and off, respectively. Therefore, the potential of the data OUT rises in accordance with a rise in the potential of the output enable signal OE and reaches $V_{cc}$—$V_{th}$ while the potential of the data $\overline{OUT}$ remains low $(V_{ss})$. As a result, the transistors $Q_{23}$ and $Q_{24}$ are turned on and off, respectively, and thereby high level data having a potential $V_{cc}$—$2V_{th}$ is obtained as the output data DO. Contrary to this, when the potentials of the data output lines D and $\bar{D}$ are low $(V_{ss})$ and high $(V_{cc})$, respectively, low level data having a potential $V_{ss}$ is obtained as the output data DO. This is the normal operation of the circuit of Figure 3.

Next, the transient, or abnormal, operation of the circuit of Figure 3, will be explained with reference to Figure 5. Assume that the signals $\overline{RAS}$ and $\overline{CAS}$ both remain low $(V_{ss})$ and, in addition, that the power supply $V_{cc}$ is turned on, that is that the potential $V_{cc}$ is gradually increased. In this case, the potential of the column enable signal CE rises in accordance with a rise in the potential $V_{cc}$ due to the capacitive coupling of the gate and drain of the transistor $Q_1$. The rise of the potential of the signal CE turns on the transistor $Q_1$, with the result that the potential at the node $N_1$ rises in accordance with a rise in the potential of the signal CE. However, the potential of the signal $\overline{CE}$ remains low $(V_{ss})$. As a result, the transistor $Q_4$ is turned on so that the potential at the node $N_2$ also remains low $(V_{ss})$. Therefore, the transistors $Q_{11}$ and $Q_{13}$ are completely turned off. In addition, since the signal CE is transmitted to the gate of the transistor $Q_6$, the transistor $Q_6$ is turned on, with the result that the potential at the node $N_3$ also remains low $(V_{ss})$. As a result, the transistor $Q_7$ is turned off. On the other hand, since the signal $\overline{CE}$ is transmitted to the gate of the transistor $Q_8$, the transistor $Q_8$ is also turned off. Therefore, the node $N_4$ is in a floating state. In this state, as the potential $V_{cc}$ increases, the potential at the node $N_4$ also increases due to the capacitive coupling of the gate and drain of the transistor $Q_9$. Further, the potential of the output enable signal OE also increases due to the capacitive coupling of the gate and source of the transistor $Q_{12}$.

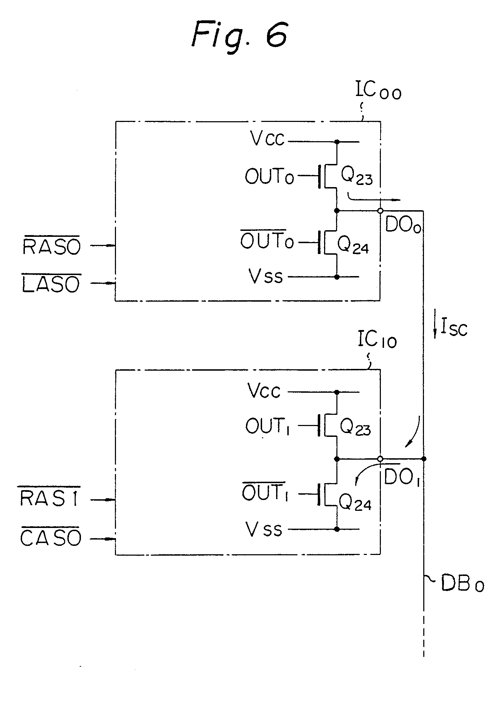

In the above-mentioned state, however, if the potential of the data output line D is high and the potential of the data output line $\bar{D}$ is low, or vice versa, which may often occur in a transient state when the power supply is turned on, the potential of the output data DO may be high or low in accordance with the condition of the output data lines D and $\bar{D}$. Such a phenomenon causes a serious problem in the memory system of Figure 1 since, for example, the memory devices $IC_{00}$, $IC_{10}$, $IC_{20}$, and $IC_{30}$ are connected to a common data bus. This serious problem is explained with reference to Figure 6.

In Figure 6, the memory devices $IC_{00}$ and $IC_{10}$ are commonly connected to the data bus $DB_0$. In a transient state when the power supply $V_{cc}$ is turned on, the signals $\overline{RAS0}$, $\overline{CAS0}$, $\overline{RAS1}$, and $\overline{CAS1}$ are not stationary. That is, the potentials thereof are determined in accordance with the sequence of turning on the power supplies, including the power supply $V_{cc}$, the fluctuation of the characteristics of each memory device, and the like. Therefore, at worst, the potentials of the signals $\overline{RAS0}$, $\overline{CAS0}$, $\overline{RAS1}$, and $\overline{CAS1}$ become low. As a result, both the output transistor Q23 of the memory device $IC_{00}$ and the output transistor $Q_{24}$ of the memory device $IC_{10}$ may be turned on, thereby causing a large DC short-circuit current $I_{sc}$ to flow through both of the transistors.

Note that usually each output transistor has the capacity to supply a current of about 100 mA to the data bus $DB_0$, which has a capcity of about 100 pF. Therefore, in a normal operation, only an AC current flows through each output transistor.

The above-mentioned DC short-circuit current $I_{sc}$ may cause the output transistors to be damaged and may cause the aluminum connections within the memory devices to be disconnected.

In an embodiment of the present invention, when the power supply $V_{cc}$ is turned on the generation of an output enable signal OE is stopped in order for the data output buffer, that is the output transistors, to assume a high-impedance state.

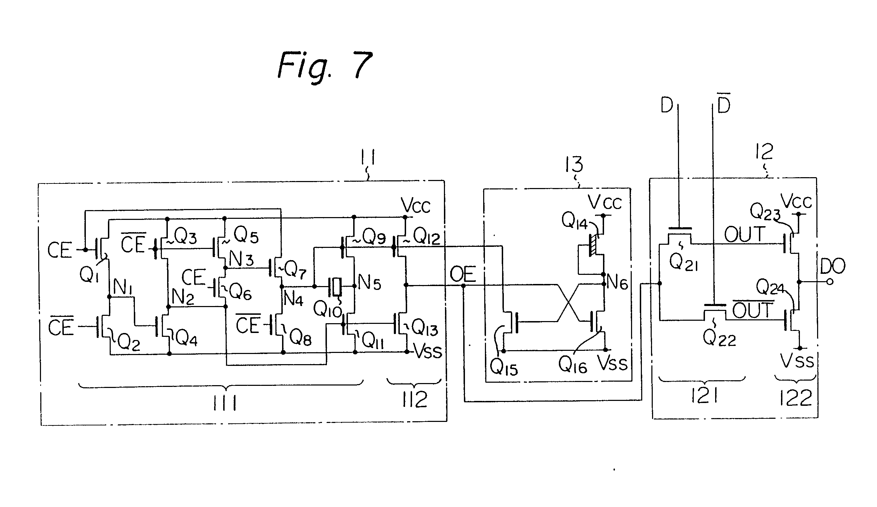

In Figure 7, which illustrates an embodiment of the present invention, an output disabling circuit 13 is added to the circuit of Figure 3. The output disabling circuit 13 comprises a depletion-type transistor $Q_{14}$ and two enhancement-type transistors $Q_{15}$ and $Q_{16}$. The transistor $Q_{15}$ is connected to the bootstrapped node $N_4$ of the bootstrap circuit 111. In addition, the transistor $Q_{16}$ is connected, via the transistor $Q_{14}$ which serves as a load, to the power supply $V_{cc}$.

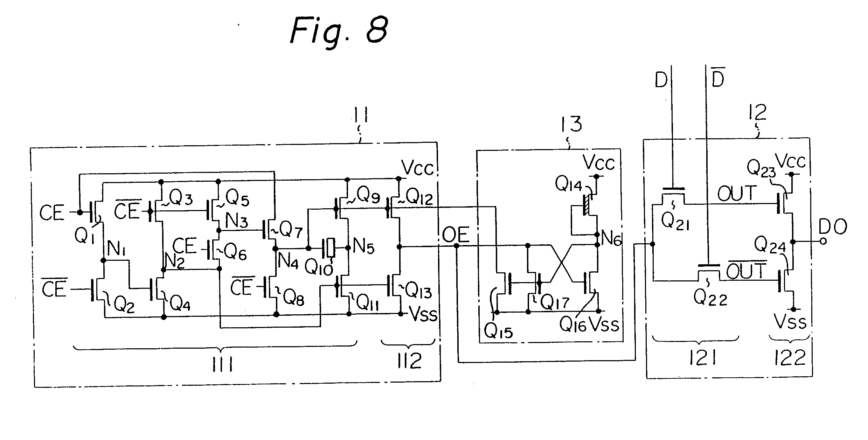

In Figure 8, which illustrates another embodiment of the present invention, a transistor $Q_{17}$ is added to the output disable circuit of Figure 7.

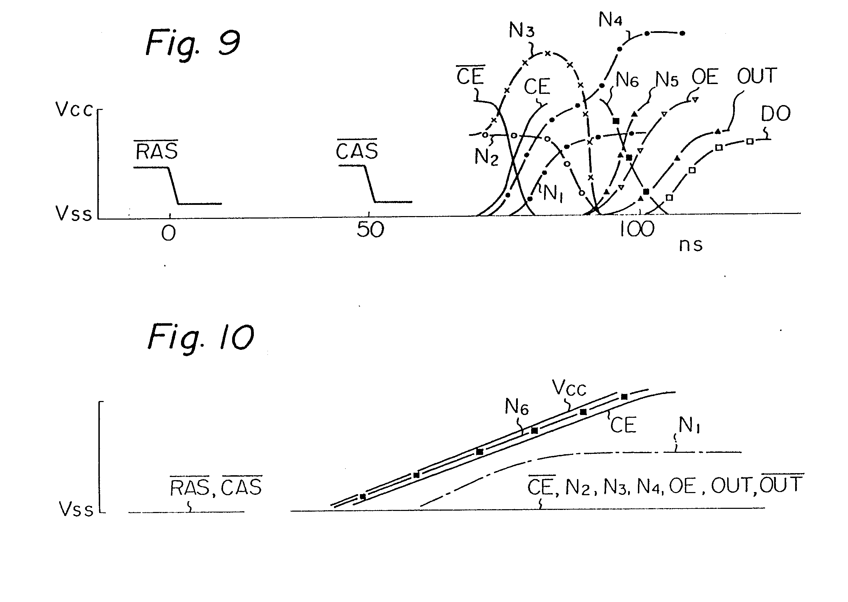

The normal operation of the circuit of Figures 7 and 8 will now be explained with reference to Figure 9. In the same way as in Figure 4, when the signals RAS and CAS, respectively, are generated, a row address and a column address are taken in. After that, the pushing up of the potential at the node $N_3$, the rising of the potential at the nodes $N_1$ and $N_4$, the falling of the potential at the node $N_2$, and the rising of the potential at the node $N_5$ occur.

4

In the output disabling circuit 13, the potential at the node $N_6$ is increased to the power supply voltage $V_{cc}$ due to the load transistor $Q_{14}$. Accordingly, at first, the potential at the node $N_6$ remains high ($V_{cc}$). When the potential at the node $N_6$ remains high, although the transistors $Q_{15}$, and $Q_{17}$ (Figure 8), are turned on and the transistor $Q_{16}$ is turned off, the transistors $Q_{15}$ and $Q_{17}$ cannot prevent the potential at the bootstrapped node $N_4$ and the potential of the output enable signal OE from rising. The reason for this is that the driving power of the transistors $Q_{15}$ and $Q_{17}$ is small. Therefore, when the potential of the output enable signal OE becomes sufficiently high, the transistor $Q_{16}$ is turned on to decrease the potential at the node $N_6$. As a result, the transistors $Q_{15}$ and $Q_{17}$ are turned off. Thus, the output enable signal OE can serve as a power supply for the data output buffer 12. That is, in a normal state or a stationary state, the presence of the output disabling circuit 13 presents no obstacle in the operation of the output enable buffer 11.

Next, the transient, or abnormal, operation of the circuit Figures 7 and 8 will be explained with reference to Figure 10. Assume that the signals $\overline{RAS}$ and $\overline{CAS}$ both remain low ($V_{ss}$) and, in addition, that the power supply $V_{cc}$ is turned on, that is that the potential $V_{cc}$ is gradually increased. In this case, the potential of the column enable signal CE rises in accordance with a rise in the potential $V_{cc}$ due to the capacitive coupling of the gate and drain of the transistor $Q_1$. In the output disabling circuit 13, the potential at the node $N_6$ definitely rises in accordance with a rise in the potential $V_{cc}$ due to the presence of the depletion-type transistor $Q_{14}$ so as to turn on the transistor $Q_{15}$, and $Q_{17}$, and turn off the transistor $Q_{16}$. In the output enable buffer 11, the rising of the signal CE turns on the transistors $Q_1$ and $Q_6$ while the transistors $Q_2$, $Q_3$, $Q_5$, and $Q_8$ remain in the off state since the potential of the signal $\overline{CE}$ remains low ($V_{ss}$). The rising of the potential of the signal CE turns on the transistor $Q_1$, with the result that the potential at the node $N_1$ rises in accordance with a rise in the potential of the signal CE. However, the potential at the node $N_2$ does not change since it is already low before the transistor $Q_4$ is turned on. Also, the potential at the node $N_3$ does not change, that is, it remains low ($V_{ss}$).

Although the potential at the node $N_4$ would normally rise, due to the capacitive coupling of the gate and drain of the transistor $Q_9$, in the same manner as the potential of the signal CE, in this case, it does not rise since the transistor $Q_{15}$ of the output disabling circuit 13 is turned on. Therefore, the transistors $Q_9$ and $Q_{12}$ are turned off, and the potential at the node $N_5$ and the potential of the output enable signal OE do not rise. Further, in Figure 8, the transistor $Q_{17}$ prevents the signal OE from rising.

In the data output buffer 12, since the potential of the output enable signal OE is low ($V_{ss}$), the potential of the data $\overline{OUT}$ and the data OUT is low ($V_{ss}$) regardless of the potential of the output data lines D and $\overline{D}$. As a result, the transistors $Q_{23}$ and $Q_{24}$ are both turned off, and, accordingly, the terminal for the output data DO assumes a high-impedance state. Therefore, if a plurality of memory devices using the circuits of Figure 7 or 8 are combined to form a memory system as is illustrated in Figure 1, no short-circuit current $I_{SC}$ flows therethrough.

In order to definitely raise the potential at the node $N_6$ when the power supply $V_{cc}$ is turned on, it is necessary that the threshold voltage of the transistor $Q_{16}$ be higher than that of the transistor $Q_{17}$ (Figure 8).

In order to perform a memory access operation such as a read operation, it is necessary to make the signals $\overline{RAS}$ and $\overline{CAS}$ high in advance, i.e. to carry out a so-called stand-by operation. In the stand-by mode, the potentials of the signals CE and $\overline{CE}$ are low ($V_{ss}$) and high ($V_{cc}$), respectively, so that the transistors $Q_2$, $Q_3$, $Q_5$, and $Q_8$ are turned on and the transistors $Q_1$ and $Q_6$ are turned off. As a result, the potential at the node $N_1$ is low so as to turn off the transistor $Q_4$ while the potential at the node $N_2$ is high ($V_{cc}$—$V_{th}$) so as to turn on the transistors $Q_{11}$ and $Q_{13}$. In addition, the potential at the node $N_3$ is high ($V_{cc}$—$V_{th}$) so as to charge the node $N_4$. Thus, the stand-by operation in preparation for a bootstrap operation and the like is completed. Then the signals $\overline{RAS}$ and $\overline{CAS}$, respectively, are made low ($V_{ss}$), and the operation illustrated in Figure 8 and Figure 9 begins.

In a dynamic RAM, even when the power supply is turned on, the potential at each portion has a tendency to fall toward $V_{ss}$, due to a junction leak or the like, even if no memory operation is performed. Therefore, in a memory system using the prior art circuit of Figure 3, the state for generating a short-circuit current does not continue for a long time. That is, after several seconds or several milliseconds have passed, the potential at each terminal for data $DO_1$ and $DO_2$, shown in Figure 6, becomes low, and, accordingly, the above-mentioned short-circuit current is extinguished. However, it should be noted that the several seconds, or several milliseconds, during which a state for generating a short-circuit exists is a considerably long time in the case of a dynamic RAM which operates on the order of nsec. Therefore, in the prior art, it is important that the power supply be turned on only when the signals $\overline{RAS}$ and $\overline{CAS}$ are high. In contrast, in an embodiment of the present invention, such a limitation is unnecessary.

As was explained hereinbefore, in a memory system having a plurality of memory devices embodying the present invention, arranged in rows and columns, no short-circuit current is generated when a power supply is turned on.

**Claims**

1. A semiconductor memory device comprising:
   first and second power supply lines ($V_{ss}$, $V_{cc}$), the said second power supply line ($V_{cc}$) being maintained at a high potential than the first when the device is in normal operation;
   data output circuitry (12), connected between the said first and second power supply lines ($V_{ss}$, $V_{cc}$),

having respective inputs for receiving data signals (D, $\bar{D}$) and an output enable signal (OE) and operative, upon receipt of the said output enable signal (OE), to provide an output signal (DO) dependent upon the received data signals (D, $\bar{D}$); and

output enabling circuitry (11), connected between the said first and second power supply lines ($V_{ss}$, $V_{cc}$), having inputs for receiving clock signals (CE, $\overline{CE}$) and having an output stage (112), connected to the said data output circuitry (12), for delivering the said output enable signal (OE) at times determined by the received clock signals (CE, $\overline{CE}$) when the device is in normal operation, which output enabling circuitry (11) includes a bootstrap circuit arrangement (111) having a node ($N_4$) connected to an input of the output stage (112) so as to cause the said output enable signal (OE) to be produced when the potential at the said node ($N_4$) is pulled up by bootstrap action initiated by a received clock signal (CE, $\overline{CE}$);

characterised by output disabling circuitry (13), connected between the said first and second power supply lines ($V_{ss}$, $V_{cc}$) and to the said output enabling circuitry (11), for preventing the generation of the said output enable signal (OE) during an initial period of time, following application of power to the first and second supply lines ($V_{ss}$, $V_{cc}$), during which the potential of the said second power supply line ($V_{cc}$) is increasing to its normal operating value, without preventing the said bootstrap action and consequent production of the said output enable signal (OE) during subsequent normal operation.

2. A device as claimed in claim 1, wherein the said output disabling circuitry (13) comprises:

a load ($Q_{14}$) having a first terminal connected to the said second power supply line ($V_{cc}$) and a second terminal ($N_6$) connected to a drain of a first enhancement-type transistor ($Q_{16}$), the said first transistor ($Q_{16}$) having a source connected to the said first power supply line ($V_{ss}$) and a gate connected to an output terminal of the said output enabling circuitry (11), at which output terminal the said output enable signal (OE) is delivered; and

a second enhancement-type transistor ($Q_{15}$) having a gate connected to the said second terminal ($N_6$) of the load ($Q_{14}$), a source connected to the said first power supply line ($V_{ss}$), and a drain connected to the said node ($N_4$) of the said bootstrap circuit arrangement (111).

3. A device as claimed in claim 2, wherein the said output disabling circuitry (13) further comprises a third enhancement-type transistor ($Q_{17}$) having a gate connected to the said second terminal ($N_6$) of the load ($Q_{14}$), a drain connected to the said gate of the said first transistor ($Q_{16}$), and a source connected to the said first power supply line ($V_{ss}$).

4. A device as claimed in claim 2 or 3, wherein the said load ($Q_{14}$) comprises a depletion-type transistor ($Q_{14}$) having a gate connected to its said second terminal ($N_6$).

5. A device as claimed in any preceding claim, wherein the said data output circuitry (12) comprises:

a data output stage (122), connected between the said first and second power supply lines ($V_{ss}$, $V_{cc}$), for delivering the said output signal (DO); and

data transfer circuitry (121) having respective inputs for receiving the said data signals (D, $\bar{D}$) and the said output enable signal (OE) and at least one output connected to the said data output stage (122) and operative, under the control of the received data signals (D, $\bar{D}$), to transfer the received output enable signal (OE) to the said data output stage (122) so as to cause the data output stage (122) to deliver an output signal (DO) dependent upon the said data signals (D, $\bar{D}$).

6. A device as claimed in claim 5, wherein the said data transfer circuitry (121) comprises two enhancement-type transistors ($Q_{21}$, $Q_{22}$), having respective gates for receiving respective ones of the data signals (D, $\bar{D}$), and respective source-drain paths connected, in parallel, between the said output enabling circuitry (11) and respective inputs of the said data output stage (122).

7. A device as claimed in claim 5 or 6, wherein the said data output stage (122) comprises two enhancement-type transistors ($Q_{23}$, $Q_{24}$) having respective gates connected to respective outputs of the data transfer circuitry (121).

8. An array of semiconductor memory devices, each of which is a device as claimed in any preceding claim, which devices have respective output terminals at which their respective output signals (DO) are provided during normal operation and which are connected to one another by way of a common data bus (DB).

**Patentansprüche**

1. Halbleiterspeichervorrichtung mit:

ersten und zweiten Energieversorgungsleitungen ($V_{ss}$, $V_{cc}$), von denen die genannte zweite Energieversorgungsleitung ($V_{cc}$) auf einem höheren Potential als die erste gehalten wird, wenn die Vorrichtung im normalen Betrieb ist;

einer Datenausgangsschaltung (12), die zwischen den genannten ersten und zweiten Energieversorgungsleitungen ($V_{ss}$, $V_{cc}$) verbunden ist und jeweilige Eingänge zum Empfang von Datensignalen (D, $\bar{D}$) und eines Ausgabefreigabesignal (OE) hat und, bei Empfang des genannten Ausgangsfreigabesignals (OE), betriebsfähig ist und ein Ausgangssignal (DO) liefert, welches von den empfangenen Datensignalen (D, $\bar{D}$) abhängt; und

einer Ausgangsfreigabeschaltung (11), welche zwischen den genannten ersten und zweiten Energieversorgungsleitungen ($V_{ss}$, $V_{cc}$) angeschlossen ist und Eingänge zum Empfang von Taktsignalen (CE, $\overline{CE}$) und eine Ausgangsstufe (112) hat, die mit der genannten Datenausgangsschaltung (12) verbunden ist, um

6

das genannte Ausgangsfreigabesignal (OE) zu Zeitpunkten, die durch die empfangenen Taktsignale (CE, $\overline{CE}$) bestimmt werden, zu liefern, wenn die Vorrichtung im normalen Betrieb ist, welche Ausgangsfreigabeschaltung (11) eine Bootstrap-Schaltungsanordnung (111) enthält, die einen Knotenpunkt ($N_4$) hat, der mit einem Eingang der Ausgangsstufe (112) so verbunden ist, daß die Erzeugung des Ausgangsfreigabesignales (OE) bewirkt wird, wenn das Potential an dem genannten Knotenpunkt ($N_4$) durch eine Bootstrap-Aktion, welche durch ein empfangenes Taktsignal (CE, $\overline{CE}$) initiiert wird, hochgezogen wird;

gekennzeichnet durch eine Ausgangssperrschaltung (13), die zwischen den genannten ersten und zweiten Energieversorgungsleitungen ($V_{ss}$, $V_{cc}$) und der genannten Ausgangsfreigabeschaltung (11) verbunden ist, um die Erzeugung des genannten Ausgangsfreigabesignals (OE) während einer anfänglichen Zeitperiode, nach der Zuführung von Energie zu den ersten und zweiten Energieversorgungsleitungen ($V_{ss}$, $V_{cc}$), zu verhindern, während welcher das Potential der genannten zweiten Energieversorgungsleitung ($V_{cc}$) auf seinen normalen Betriebswert anwächst, ohne die Bootstrap-Aktion und die folgende Produktion des genannten Ausgangsfreigabesignals (OE) während des folgenden normalen Betriebs zu verhindern.

2. Vorrichtung nach Anspruch 1, bei der die genannte Ausgangssperrschaltung (13) umfaßt:
eine Last ($Q_{14}$), die einen ersten Anschluß hat, der mit der genannten zweiten Energieversorgungsleitung ($V_{cc}$) verbunden ist, und einen zweiten Anschluß ($N_6$), der mit einem, Drain eines ersten Anrechungstyp-Transistors ($Q_{16}$) verbunden ist, welcher genannte erste Transistor ($Q_{16}$) eine Source hat, die mit der genannten ersten Energieversorgungsleitung ($V_{ss}$) verbunden ist, und ein Gate, das mit einem Ausgangsanschluß der genannten Ausgangsfreigabeschaltung (11) verbunden ist, an welchen Ausgangsanschluß das genannte Ausgangsfreigabesignal (OE) geliefert wird; und
einen zweiten Anreicherungstyp-Transistor ($Q_{15}$), der ein Gate hat, das mit dem genannten zweiten Anschluß ($N_6$) der Last ($Q_{14}$) verbunden ist, eine Source, die mit der genannten ersten Energieversorgungsleitung ($V_{ss}$) verbunden ist, und ein Drain, das mit dem genannten Knotenpunkt ($N_4$) der genannten Bootstrap-Schaltungsanordnung (111) verbunden ist.

3. Vorrichtung nach Anspruch 2, bei der die genannte Ausgangssperrschaltung (13) ferner einen dritten Anreicherungstyp-Transistor ($Q_{17}$) umfaßt, der ein Gate hat, das mit dem genannten zweiten Anschluß ($N_6$) der Last ($Q_{14}$) verbunden ist, ein Drain, das mit dem genannten Gate des ersten Transistors ($Q_{16}$) verbunden ist, und eine Source, die mit der genannten ersten Energieversorgungsleitung ($V_{ss}$) verbunden ist.

4. Vorrichtung nach Anspruch 2 oder 3, bei der die genannte Last ($Q_{14}$) einen Verarmungstyp-Transistor ($Q_{14}$) unfaßt, der ein Gate hat, das mit seinem genannten zweiten Anschluß ($N_6$) verbunden ist.

5. Vorrichtung nach einem der vorhergehenden Ansprüche, bei der die genannte Datenausgangsschaltung (12) umfaßt:
eine Datenausgangsstufe (122), die zwischen den genannten ersten und zweiten Energieversorgungsleitungen ($V_{ss}$, $V_{cc}$) verbunden ist, um das genannte Ausgangssignal (DO) zu liefern; und
eine Datentransferschaltung (121), die jeweilige Eingänge zum Empfang der genannten Datensignale (D, $\overline{D}$) und des genannten Ausgangsfreigabesignals (OE) und wenigstens einen Ausgang hat, der mit der genannten Datenausgangsstufe (122) verbunden ist, und betreibbar ist, unter der Steuerung der empfangenen Datensignale (D, $\overline{D}$), um das empfangene Ausgangsfreigabesignal (OE) zu der genannten Datenausgangsstufe (122) zu übertragen, um so zu bewirken, daß die Datenausgangsstufe (122) ein Ausgangssignal (DO) liefert, abhängig von den genannten Datensignalen (D, $\overline{D}$).

6. Vorrichtung nach Anspruch 5, bei der die genannte Datentransferschaltung (121) zwei Anreicherungstyp-Transistoren ($Q_{21}$, $Q_{22}$) umfaßt, die jeweilig Gates zum Empfang eines entsprechenden Datensignals (D, $\overline{D}$) haben, und jeweils Source-Drain-Wege, die, parallel, zwischen der genannten Ausgangsfreigabeschaltung (11) und den entsprechenden Eingängen der genannten Datenausgangsstufe (122) verbunden sind.

7. Vorrichtung nach Anspruch 5 oder 6, bei der die genannte Datenausgangsstufe (122) zwei Anreicherungstyp-Transistoren ($Q_{23}$, $Q_{24}$) umfaßt, die jeweils Gates haben, die mit entsprechenden Ausgängen der Datentransferschaltung (121) verbunden sind.

8. Anordnung von Halbleitervorrichtungen, von denen jede eine Vorrichtung nach einem der vorhergehenden Ansprüche ist, welche Vorrichtungen jeweils Ausgangsanschlüsse haben, an denen ihre entsprechenden Ausgangssignale (DO) während des normalen Betriebs geliefert werden, und die miteinander über einen gemeinsamen Datenbus (DB) verbunden sind.

**Revendications**

1. Dispositif de mémoire à semiconducteur comprenant:
des première et deuxième lignes de source d'alimentation ($V_{ss}$, $V_{cc}$), la deuxième ligne d'alimentation ($V_{cc}$) étant maintenue à un potentiel supérieur à celui de la première quand le dispositif est en fonctionnement normal;
un circuit de sortie de données (12), connecté entre les première et deuxième lignes d'alimentation ($V_{ss}$, $V_{cc}$), comportant des entrées respectives pour recevoir des signaux de données (D, $\overline{D}$) et un signal de validation de sortie (OE) et agissant, à la réception du signal de validation de sortie (OE), pour fournir un signal de sortie (DO) en fonction des signaux de données reçus (D, $\overline{D}$); et
un circuit de validation de sortie (11), connecté entre les première et deuxième lignes d'alimentation

7

($V_{ss}$, $V_{cc}$), comportant des entrées pour recevoir des signaux d'horloge (CE, $\overline{CE}$) et comportant un étage de sortie (112), connecté au circuit de sortie de données (12), pour fournir le signal de validation de sortie (OE) à des temps déterminés par les signaux d'horloge reçus (CE, $\overline{CE}$) quand le dispositif est en fonctionnement normal, ce circuit de validation de sortie (11) comprenant un agencement de circuit d'amorçage (111) comportant un noeud ($N_4$) connecté à une entrée de l'étage de sortie (112) de manière à faire en sorte que le signal de validation de sortie (OE) soit produit quand le potentiel au noeud ($N_4$) est élevé par l'action d'amorçage déclenchée par un signal d'horloge (CE, $\overline{CE}$) reçu;

caractérisé par un circuit d'invalidation de sortie (13), connecté entre les première et deuxième lignes d'alimentation ($V_{ss}$, $V_{cc}$) et au circuit de validation de sortie (11), pour empêcher la génération du signal de validation de sortie (OE) pendant une période de temps initiale, suivant l'application d'une tension d'alimentation sur les première et deuxième lignes d'alimentation ($V_{ss}$, $V_{cc}$), pendant laquelle le potentiel de la deuxième ligne d'alimentation ($V_{cc}$) augmente jusqu'à sa valeur de fonctionnement normal, sans empêcher l'action d'amorçage et la production qui s'ensuit du signal de validation de sortie (OE) pendant une opération normale suivante.

2. Dispositif selon la revendication 1, dans lequel le circuit d'invalidation de sortie (13) comprend:

une charge ($Q_{14}$) comportant une première borne connectée à la deuxième ligne d'alimentation ($V_{cc}$) et une deuxième borne ($N_6$) connectée à un drain d'un premier transistor du type à enrichissement ($Q_{16}$), le premier transistor ($Q_{16}$) comportant une source connectée à la première ligne d'alimentation ($V_{ss}$) et une grille connectée à une borne de sortie du circuit de validation de sortie (11), à la borne de sortie duquel est fourni le signal de validation de sortie (OE); et

un deuxième transistor du type à enrichissement ($Q_{15}$) comportant une grille connectée à la deuxième borne ($N_6$) de la charge ($Q_{14}$), une source connectée à la première ligne d'alimentation ($V_{ss}$), et un drain connecté au noeud ($N_4$) de l'agencement de circuit d'amorçage (111).

3. Dispositif selon la revendication 2, dans lequel le circuit d'invalidation de sortie (13) comprend en outre un troisième transistor du type à enrichissement ($Q_{17}$) comportant une grille connectée à la deuxième borne ($N_6$) de la charge ($Q_{14}$), un drain connecté à la grille du premier transistor ($Q_{16}$), et une source connectée à la première ligne d'alimentation ($V_{ss}$).

4. Dispositif selon l'une quelconque des revendications 2 et 3, dans lequel la charge ($Q_{14}$) comprend un transistor du type à épuisement ($Q_{14}$) comportant une grille connectée à sa deuxième borne ($N_6$).

5. Dispositif selon l'une quelconque des revendications 1 à 4, dans lequel le circuit de sortie de données (12) comprend:

un étage de sortie de données (122), connecté entre les première et deuxième lignes d'alimentation ($V_{ss}$, $V_{cc}$), pour fournir le signal de sortie (DO); et

un circuit de transfert de données (121) comportant des entrées respectives pour recevoir les signaux de données (D, $\overline{D}$) et le signal de validation de sortie (OE) et au moins une sortie connectée à l'étage de sortie de données (122) et agissant, sous la commande des signaux de données reçus (D, $\overline{D}$), pour transférer le signal de validation de sortie (OE) reçu jusqu'à l'étage de sortie de données (122) de manière à faire en sorte que l'étage de sortie de données (122) fournisse un signal de sortie (DO) en fonction des signaux de données (D, $\overline{D}$) reçus.

6. Dispositif selon la revendication 5, dans lequel le circuit de transfert de données (121) comprend deux transistors du type à enrichissement ($Q_{21}$, $Q_{22}$), comportant des grilles respectives pour recevoir des signaux respectifs parmi les signaux de données (D, $\overline{D}$), et des chemins de source-drain respectifs connectés, en parallèle, entre le circuit de validation de sortie (11) et les entrées respectives de l'étage de sortie de données (122).

7. Dispositif selon l'une quelconque des revendications 5 et 6, dans lequel l'étage de sortie de données (122) comprend deux transistors du type à enrichissement ($Q_{23}$, $Q_{24}$) comportant des grilles respectives connectées aux sorties respectives du circuit de transfert de données (121).

8. Matrice de dispositifs de mémoire à semiconducteur, dont chacun est un dispositif selon l'une quelconque des revendications 1 à 7, ces dispositifs comportant des bornes de sortie respectives où sont fournis leurs signaux de sortie respectifs (DO) pendant un fonctionnement normal et qui sont connectées entre elles au moyen d'un bus commun de données (DB).

# Fig. 1

— Vcc
— Vss

0 083 229

*Fig. 2*

Vcc
Vss

ROW ADDRESS DECODERS 3

MEMORY CELL ARRAY (128×256) 1-1

SENSE AMPLIFIERS (256) 2

MEMORY CELL ARRAY (128×256) 1-2

COLUMN ADDRESS DECODERS 4

$A_0 \bar{A}_0 \sim A_7 \bar{A}_7$

$A_0 \bar{A}_0 \sim A_7 \bar{A}_7$

$\bar{D}$   D

CE ($\bar{CE}$)

$\overline{RAS}$ — BF — RE — BF — RAC — DR — WD — BF — LE — BF — CE — BF — BF — OE — BF — DO

$\overline{CAS}$

5   $A_0 \sim A_7$   6   7   8   9   $A_0 \sim A_7$   10   11   12

0 083 229

Fig. 3

## Fig. 4

## Fig. 5

# Fig. 6

Fig. 7

Fig. 8

Fig. 9

Vcc

$\overline{RAS}$

$\overline{CAS}$

$\overline{CE}$   CE   N3   N4   N6   N5   OE   OUT

N2   DO

N1

Vss

0          50          100          ns

Fig. 10

Vcc

N6   Vcc   CE   N1

$\overline{RAS}, \overline{CAS}$   $\overline{CE}$, N2, N3, N4, OE, OUT, $\overline{OUT}$

Vss

0 083 229